Europäisches Patentamt

European Patent Office

Office européen des brevets

(19)

(11) **EP 0 616 648 B1**

(12) **FASCICULE DE BREVET EUROPEEN**

(45) Date de publication et mention
de la délivrance du brevet:
**19.11.1997 Bulletin 1997/47**

(21) Numéro de dépôt: **93902319.8**

(22) Date de dépôt: **11.12.1992**

(51) Int Cl.⁶: **C23C 14/34**, C23C 14/08

(86) Numéro de dépôt international:
**PCT/FR92/01172**

(87) Numéro de publication internationale:
**WO 93/12264 (24.06.1993 Gazette 1993/15)**

(54) **PROCEDE DE PREPARATION D'UN ELEMENT DE CIBLE POUR PULVERISATION CATHODIQUE**

VERFAHREN ZUM HERSTELLEN EINES TARGETELEMENTES ZUR KATODENZERSTÄUBUNG

METHOD FOR PREPARING A TARGET ELEMENT FOR CATHODE SPUTTERING

(84) Etats contractants désignés:
**AT BE CH DE DK ES FR GB GR IE IT LI LU MC NL PT SE**

(30) Priorité: **13.12.1991 FR 9115537**

(43) Date de publication de la demande:
**28.09.1994 Bulletin 1994/39**

(73) Titulaire: **ELF AQUITAINE**
**92400 Courbevoie (FR)**

(72) Inventeurs:
- **CAMPET, Guy**
  **F-33610 Canejan (FR)**
- **BOURREL, Maurice**
  **F-64000 Pau (FR)**
- **DELMAS, Claude**
  **F-33400 Talence (FR)**
- **PORTIER, Joseph**
  **F-33170 Gradignan (FR)**
- **SALARDENNE, Jean**
  **F-33600 Pessac (FR)**

(74) Mandataire: **Boillot, Marc**
**Elf Exploration Production**
**Département Propriété Industrielle**
**Tour Elf**
**EP/T/RD/DPI - Bureau 34 G 47**
**92078 Paris La Défense Cedex (FR)**

(56) Documents cités:
**EP-A- 0 342 537**          **DE-A- 2 608 323**

- **PHYSICA vol. C156, no. 3, 1 Octobre 1988, NORTH-HOLLAND, AMSTERDAM pages 477 - 480 D.G.HINKS ET AL 'OXYGEN CONTENT AND THE SYNTHESIS OF BA1-XKXBIO3-Y'**
- **NATURE vol. 338, no. 6212, 16 Mars 1989, LONDON GB pages 241 - 243 H. SATO 'OPTICAL STUDY OF THE METAL-INSULATOR TRANSITION ON BA1-XKXBIO3 THIN FILMS'**
- **PATENT ABSTRACTS OF JAPAN vol. 10, no. 328 (C-383)(2384) 7 Novembre 1986& JP-A-61 136 673**
- **PATENT ABSTRACTS OF JAPAN vol. 9, no. 217 (P-385)(1940) 4 Septembre 1985& JP-A-60 078 423**
- **JAPANESE JOURNAL OF APPLIED PHYSICS vol. 20, no. 1, 1 Janvier 1981, TOKYO JAPAN pages 48 - 50 T. MITSUYO 'HIGH DIELECTRIC CONSTANT FILMS OF AMORPHOUS LINBO3 PREPARED BY SPUTTERING DEPOSITION'**
- **DATABASE WPI Derwent Publications Ltd., London, GB; AN 75-62830W 38 & JP-A-49 125 900**
- **PATENT ABSTRACTS OF JAPAN vol. 14, no. 134 (C-701)(4077) 14 Mars 1990& JP-A-2 008 364**
- **PATENT ABSTRACTS OF JAPAN vol. 12, no. 248 (C-511)(3095) 13 Juillet 1988& JP-A-63 035 769**

Remarques:
Le dossier contient des informations techniques présentées postérieurement au dépôt de la demande et ne figurant pas dans le présent fascicule.

## Description

L'invention a trait à un procédé de préparation d'un élément de cible pour pulvérisation cathodique. Elle se rapporte encore à la réalisation de cibles, notamment cibles de grande surface, à partir de cet élément.

Le revêtement de matériaux divers par des couches minces à propriétés particulières connaît actuellement un développement considérable. On peut citer notamment le dépôt de couches anticorrosion sur les métaux, de couches antireflet sur les verres d'optique ou encore le dépôt de matériaux ultradurs sur des pièces mécaniques.

De nombreuses méthodes ont été proposées pour la réalisation de telles couches, lesdites méthodes dépendant, entre autres, de la nature du ou des composés générateurs de la couche de revêtement. Ainsi, lorsque lesdits composés générateurs sont gazeux, on peut faire appel aux diverses méthodes de dépôt chimique en phase vapeur assisté ou non par plasma. Avec des composés générateurs liquides ou susceptibles d'être mis en solution, on peut employer des méthodes électrochimiques, s'il s'agit de déposer une couche d'un métal, ou encore utiliser des méthodes telles que celles dites de dépôt à la tournette (en anglais "spin coating") ou de dépôt par pulvérisation d'un brouillard chaud (en anglais "hot spray").

Dans le cas où la source génératrice du revêtement est un matériau solide, la méthode la plus utilisée pour réaliser le revêtement est la pulvérisation cathodique. Dans une telle méthode, le matériau solide générateur du revêtement, que l'on désigne généralement par le vocable "matériau cible" ou "cible" et qui peut être constitué par un métal ou un alliage métallique ou bien encore consister en un composé chimique inorganique à point de fusion très élevé, par exemple une céramique ou un oxyde réfractaire, est bombardé par des ions ayant une énergie suffisante pour arracher des particules du matériau cible, lesdites particules se déposant sur l'objet à revêtir en formant sur ce dernier le revêtement recherché.

Pour des raisons d'homogénéité et de vitesse de croissance du dépôt formé des particules arrachées au matériau cible, il est nécessaire que la surface dudit matériau cible à déposer sur l'objet soit de taille suffisante. Dans le cas du revêtement d'objets de grande surface, vitrages par exemple, on est ainsi conduit à utiliser des cibles de grande surface, dont la surface est avantageusement plus grande que celle de l'objet à revêtir.

Si la fabrication de cibles de grande surface à partir de métaux ou d'alliages métalliques ne pose pas de problèmes, il n'en est plus de même lorsqu'il s'agit de matériaux du type des composés chimiques inorganiques à point de fusion élevé. En effet, pour de tels matériaux, la fabrication de la cible passe par la réalisation d'une céramique ou d'un produit fritté constitué desdits matériaux. La réalisation d'une céramique ou d'un produit fritté de grande surface nécessite la mise au point, au coup par coup, du procédé le plus approprié, une telle mise au point étant le plus souvent longue , difficile et par conséquent onéreuse et de plus elle doit être faite impérativement par un spécialiste.

Dans un article publié dans la revue Physica C 156, n°3 (1 octobre 1988), pages 477 à 480, D.G HINKS et al décrivent un procédé en deux étapes pour la préparation d'un matériau céramique $Ba_{(1-x)}K_xBiO_{(3-y)}$. Dans ce procédé, qui utilise BaO préparé par chauffage de $BaCO_3$ sous vide à 1000°C jusqu'à ce que le dégagement de $CO_2$ ait cessé, on porte, dans une première étape, un mélange de BaO, $KO_2$ et $Bi_2O_3$ à 725°C pendant une heure, puis, dans une deuxième étape, on soumet le produit obtenu dans la première étape à un recuit en présence d'oxygène pour former un matériau stable constituant le produit $Ba_{(1-x)}K_xBiO_{(3-y)}$.

Comme indiqué par H. SATO et al, dans un article publié dans la revue Nature, Volume 336 (16 mars 1989), pages 241 à 243, le matériau céramique précité, obtenu comme décrit par D.G HINKS et al, peut être utilisé comme cible pour pulvérisation cathodique radiofréquence en vue d'effectuer une croissance épitaxiale de films minces de $Ba_{(1-x)}K_xBiO_3$ sur des supports de $SrTiO_3$ maintenus à 400°C.

L'invention propose un procédé simple, rapide et peu onéreux pour la préparation d'un élément de cible pour pulvérisation cathodique en un matériau inorganique céramique possédant un point de fusion supérieur à 300°C et ayant la formule d'un oxyde, sulfure, halogénure ou oxyhalogénure d'un ou plusieurs métaux qui peuvent être ou non des métaux de transition. Un tel procédé peut être mis en oeuvre par des personnes n'ayant pas de compétences particulières dans l'art de la céramique ou du frittage et il conduit aisément à l'obtention d'éléments de cible permettant de réaliser facilement des cibles de grande surface.

Le procédé selon l'invention se caractérise en ce que l'on constitue un système précurseur du matériau inorganique susceptible de donner naissance audit matériau à des températures e comprises entre 300°C et 1600°C et inférieures au point de fusion de ce matériau, ledit système précurseur renfermant au moins 20% molaire d'un adjuvant inorganique consistant en au moins un composé inorganique ayant un point de fusion inférieur ou égal à la température e choisie pour la production du matériau inorganique, on forme une couche dudit système précurseur sur un support, qui est sensiblement inerte vis à vis du système précurseur et du matériau inorganique céramique à produire et qui est thermiquement et mécaniquement stable jusqu'à des températures supérieures à e, à l'exclusion d'un support en mousse ou en feutre métallique, on porte l'ensemble support/système précurseur à la température e choisie pour produire le matériau inorganique, avec une vitesse de montée en température propre à éviter la formation de dendrites, puis l'on maintient ledit ensemble à cette température e pendant une durée suffisante pour transformer le système précurseur en ledit matériau inorganique céramique, et l'on refroidit ensuite l'ensemble support/matériau inorganique pour le ramener à la température ambiante en réalisant ce refroidissement de manière à éviter tout phénomène de trempe.

En particulier, le matériau inorganique formant l'élément de cible peut répondre à l'une ou l'autre des formules $E_\alpha^k Z_\beta^p$ et $M_x^q T_y^n Z_z^p$ dans lesquelles E représente au moins un métal des groupes I à VIII du Tableau Périodique des Eléments, par exemple Fe, Cu, Co, Ni, Ti, Cr, Mo, Sn, W et In, M et T désignent au moins deux métaux différents des groupes I à VIII dudit Tableau Périodique, par exemple Li, Na, K, Ag, Cu et Tl pour M et Ni, Co, W, Mn, Fe, Cr, V et Ti pour T, Z est au moins un élément choisi parmi oxygène, soufre, fluor et chlore, les symboles k, q, n et p désignent les degrés d'oxydation moyens des éléments E, M, T et Z respectivement, $\alpha$ et $\beta$ désignent des nombres entiers positifs tels que $\alpha k + \beta p = 0$ et x, y et z désignent des nombres entiers positifs tels que $qx + ny + pz = 0$.

Le terme degré d'oxydation moyen, appliqué à chaque élément, traduit le fait que l'élément concerné peut avoir plusieurs degrés d'oxydation dans le composé considéré.

Le matériau inorganique peut être tout spécialement un oxyde et notamment un oxyde ayant l'une ou l'autre des formules $E_\alpha^k O_\beta^{2-}$ et $M_x^q T_y^n O_z^{2-}$ dans lesquelles E est au moins un métal des groupes I à VIII du Tableau Périodique des Eléments, par exemple Fe, Cu, Co, Ni, W, Mo, Ti, Cr, Sn et In, M et T désignent au moins deux métaux différents dudit Tableau Périodique, par exemple Li, Na, K, Ag, Cu et Tl pour M et Ni, Co, W, Mn, Cr, Fe, V et Ti pour T, les symboles k, q et n désignant les degrés d'oxydation moyens de E, M et T respectivement, $\alpha$ et $\beta$ sont des nombres entiers positifs tels que $\alpha k - 2\beta = 0$ et x, y et z désignent des nombres entiers positifs tels que $qx + ny - 2z = 0$. Comme exemples de tels oxydes on peut citer à titre non limitatif $WO_3$, $MoO_3$, $Cr_2O_3$, $TiO_2$, $Fe_2O_3$, $Li_{2-v} NiO_2$ avec $0 \le v \le 1$, $LiCrO_2$, $LiFeO_2$ $LiWO_3$ et $Li_2WO_4$.

L'adjuvant inorganique présent dans le mélange précurseur du matériau inorganique peut être choisi notamment parmi les halogénures, en particulier fluorures et chlorures, et les carbonates des métaux alcalins, notamment sodium, lithium et potassium. Par exemple, l'adjuvant inorganique peut consister en un ou plusieurs composés tels que fluorure de lithium, chlorure de lithium, carbonate de lithium, carbonate de sodium et carbonate de potassium.

Avantageusement, le système précurseur du matériau inorganique renferme entre 20% et 80% molaire de l'adjuvant inorganique.

Le système précurseur du matériau inorganique peut consister en le matériau inorganique lui même, comme c'est le cas notamment pour les matériaux inorganiques précités de formule $E_\alpha^k Z_\beta^p$ et notamment pour les oxydes de formule $E_\alpha^k O_\beta^{2-}$ tels que ceux mentionnés précédemment. Le système précurseur du matériau inorganique peut être également formé d'un mélange d'ingrédients conduisant, par réaction chimique à des températures inférieures ou égales à $\theta$, au matériau inorganique envisagé. Ainsi, lorsque le matériau inorganique consiste en un composé de formule $M_x^q T_y^n Z_z^p$ et notamment en un oxyde de formule $M_x^q T_y^n O_z^{2-}$, le système précurseur du matériau inorganique peut consister en un mélange, en proportions appropriées, d'au moins un composé de métal M et d'au moins un composé de métal T, qui sont susceptibles de former le composé $M_x^q T_y^n Z_z^p$ ou le composé de $M_x^q T_y^n O_z^{2-}$ à la température $\theta$. Par exemple, lorsque le matériau inorganique est un oxyde de formule $M_x^q T_y^n O_z^{2-}$, c'est-à-dire une céramique du type oxyde mixte, le mélange précurseur d'un tel oxyde peut consister avantageusement en un mélange d'au moins un carbonate de métal M de formule $M_x^q (CO_3)_{\frac{qx}{2}}$ et d'au moins un oxyde de métal T de formule $T_y^n O_{ny/2}^{2-}$. Ainsi, à partir d'un système précurseur renfermant des quantités équimoléculaires de $Li_2CO_3$ et NiO, de $Li_2CO_3$ et $Cr_2O_3$, de $Li_2CO_3$ et $Fe_2O_3$ ou de $Li_2CO_3$ et $WO_3$ on forme respectivement les matériaux inorganiques céramiques de formules $Li_2NiO_2$, $LiCrO_2$, $LiFeO_2$ et $Li_2WO_4$.

Lorsque le système précurseur renferme un mélange d'ingrédients réagissant chimiquement à la température $\theta$ pour former le matériau inorganique envisagé et que l'un desdits ingrédients a une température de fusion inférieure ou égale à $\theta$, cet ingrédient peut constituer l'adjuvant inorganique qui doit être présent dans le système précurseur du matériau inorganique. Ainsi, lorsque l'on produit un matériau inorganique du type oxyde mixte de formule $M_x^q T_y^n O_z^{2-}$, dans laquelle M désigne un métal alcalin, notamment Li, Na ou K, à partir d'un système précurseur renfermant au moins un carbonate de métal M de formule $M_x^q (CO_3)_{\frac{qx}{2}}$ et au moins un oxyde de métal T de formule $T_y^n O_{ny/2}^{2-}$, en opérant à une température $\theta$ comprise entre le point de fusion du carbonate de métal M et 1600°C, ledit carbonate peut jouer le rôle d'adjuvant inorganique sans utilisation d'un tiers adjuvant. Par exemple, lorsque l'on produit un matériau inorganique du type oxyde mixte de formule $Li_x T_y^n O_y^{2-}$, à partir d'un système précurseur renfermant $Li_2CO_3$ et au moins un oxyde de métal T de formule $T_y^n O_{ny/2}^{2-}$, en opérant à une température $\theta$ comprise entre 723°C et 1600°C, le carbonate de lithium du système précurseur peut jouer le rôle d'adjuvant inorganique sans addition d'un tiers adjuvant.

Pour son application sur le support, le système précurseur du matériau inorganique peut se présenter sous la forme d'une poudre de granulométrie appropriée, par exemple comprise entre 5µm et 200µm et de préférence entre 10µm et 100µm. Dans ce cas, l'application du système précurseur du matériau inorganique sur le support est effectuée par saupoudrage dudit support au moyen de la poudre.

On peut également réaliser une pâte d'enduction en mélangeant la poudre du système précurseur avec un ou plusieurs liquides tels que l'eau ou un liquide organique ou bien encore préparer un gel à partir du système précurseur pulvérulent suivant l'une quelconque des techniques conventionnelles sol/gel, puis enduire le support au moyen de ladite pâte ou dudit gel.

Comme indiqué précédemment, le support sur lequel on applique la couche du système précurseur du matériau inorganique doit être sensiblement inerte vis à vis dudit matériau et de son système précurseur et en outre il doit être stable thermiquement et mécaniquement, c'est-à-dire conserver sa forme sans se détériorer, jusqu'à des températures supérieures, par exemple d'au moins 50°C, à la température θ choisie pour produire le matériau inorganique.

Le support peut être notamment un support en un métal ou alliage métallique tel que, par exemple, platine, laiton, titane, nickel, cuivre ou acier inoxydable, à l'exclusion de tout support en mousse ou feutre métallique, ou bien encore un support en une matière céramique telle que, par exemple, l'alumine ou l'oxyde de titane.

L'utilisation d'un support lisse, par exemple support métallique lisse, permet, à l'issue du refroidissement de l'ensemble matériau inorganique/support, de séparer le matériau inorganique constituant l'élément de cible d'avec le support. Par contre, en employant un support plus ou moins rugueux, le matériau inorganique reste solidaire du support. Si l'on utilise un support non lisse en une matière facilement usinable, par exemple matière céramique friable, on peut cependant isoler le matériau inorganique formant l'élément de cible en séparant mécaniquement ledit matériau inorganique d'avec le support, puis en soumettant à un usinage, par exemple meulage, la face dudit matériau inorganique constituant l'élément de cible, qui était en contact avec le support.

La température θ comprise entre 300°C et 1600°C et inférieure à la température de fusion du matériau inorganique, que l'on choisit pour produire ledit matériau inorganique à partir du système précurseur renfermant l'adjuvant inorganique, correspond à une température à laquelle le système précurseur se transforme en le matériau inorganique par frittage ou/et céramisation. De préférence, ladite température θ est choisie entre 600°C et 1200°C.

Lorsque l'application du système précurseur du matériau inorganique sur le support est réalisée par enduction au moyen de produits humides du type pâte ou gel, l'ensemble issu de l'enduction du support par la pâte ou le gel est avantageusement soumis à une étape de séchage jusqu'à l'obtention d'un produit sensiblement sec, avant la phase de montée en température pour atteindre la température θ de production du matériau inorganique.

Lorsque l'ensemble système précurseur/support est porté à la température θ, la vitesse de montée en température est avantageusement comprise entre 0,05°C et 20°C par minute et elle se situe de préférence entre 0,1°C et 10°C.

De même, lors du refroidissement de l'ensemble matériau inorganique/support depuis la température θ jusqu'à l'ambiante, on opère avantageusement avec des vitesses de refroidissement allant de 0,05°C à 20°C par minute et plus particulièrement de 0,1°C à 10°C par minute.

Le maintien de l'ensemble système précurseur/support à la température θ doit avoir lieu pendant une durée suffisante pour produire un matériau inorganique fritté ou/et céramisé à partir du système précurseur. Ladite durée peut être avantageusement comprise entre 30 minutes et 20 heures.

Lorsqu'il est produit sur un support non lisse difficilement usinable, l'élément de cible en le matériau inorganique fritté ou/et céramisé reste adhérant au support et l'ensemble matériau inorganique/support obtenu peut être utilisé directement comme cible dans un dispositif de pulvérisation cathodique.

Lorsqu'il est produit sur un support non lisse friable (facilement usinable) ou bien sur un support lisse, l'élément de cible en le matériau inorganique fritté ou/et céramisé est séparé d'avec le support, puis collé sur un substrat métallique, par exemple un substrat en laiton, titane, aluminium, cuivre, tungstène ou acier inoxydable, au moyen d'un adhésif conducteur de la chaleur et de l'électricité, pour constituer une cible pouvant être montée dans un dispositif de pulvérisation cathodique.

Selon l'invention, on peut produire directement un élément de cible de grande surface, par exemple de l'ordre de $100 cm^2$ à $1 m^2$, sur un support non lisse difficilement usinable et utiliser l'ensemble obtenu comme cible de grande surface. On peut encore produire un élément de cible de grande surface sur un support lisse ou sur un support non lisse friable, puis, après avoir séparé l'élément de cible d'avec le support, coller ledit élément, comme indiqué plus haut, sur un substrat métallique de surface correspondante pour produire une cible de grande surface.

On peut encore réaliser une cible de grande surface en produisant des éléments de cible, ayant une surface plus petite que celle de la cible de grande surface à réaliser, en faisant appel à un support non lisse friable ou à un support lisse, puis, après avoir séparé les éléments de cible d'avec leurs supports, en collant, comme indiqué ci-dessus, une pluralité desdits éléments de cible sur un substrat métallique de surface correspondant à celle de la cible de grande surface à produire, lesdits éléments de cible étant disposés sur le substrat de manière jointive pour couvrir sur ce substrat une surface correspondant à celle désirée pour la cible de grande surface.

Avantageusement, pour les cibles de petite, moyenne ou grande surface obtenues par collage, réalisé comme indiqué précédemment, d'un ou plusieurs éléments de cible sur un substrat métallique de surface appropriée, le substrat métallique présente une surface dont le contour entoure le contour de l'élément de cible unique ou de l'élément de cible résultant de la juxtaposition jointive d'éléments de cible de petite surface, lesdits contours étant de préférence parallèles entre eux, de manière à définir, sur la face du substrat métallique sur laquelle le ou les éléments de cible sont collés, un zone marginale entourant l'élément de cible. Dans cette zone marginale peuvent déboucher des orifices traversant le substrat métallique et destinés au passage d'organes de fixation, par exemple vis ou autres, permettant de fixer la cible sur un organe support appartenant au dispositif de pulvérisation cathodique.

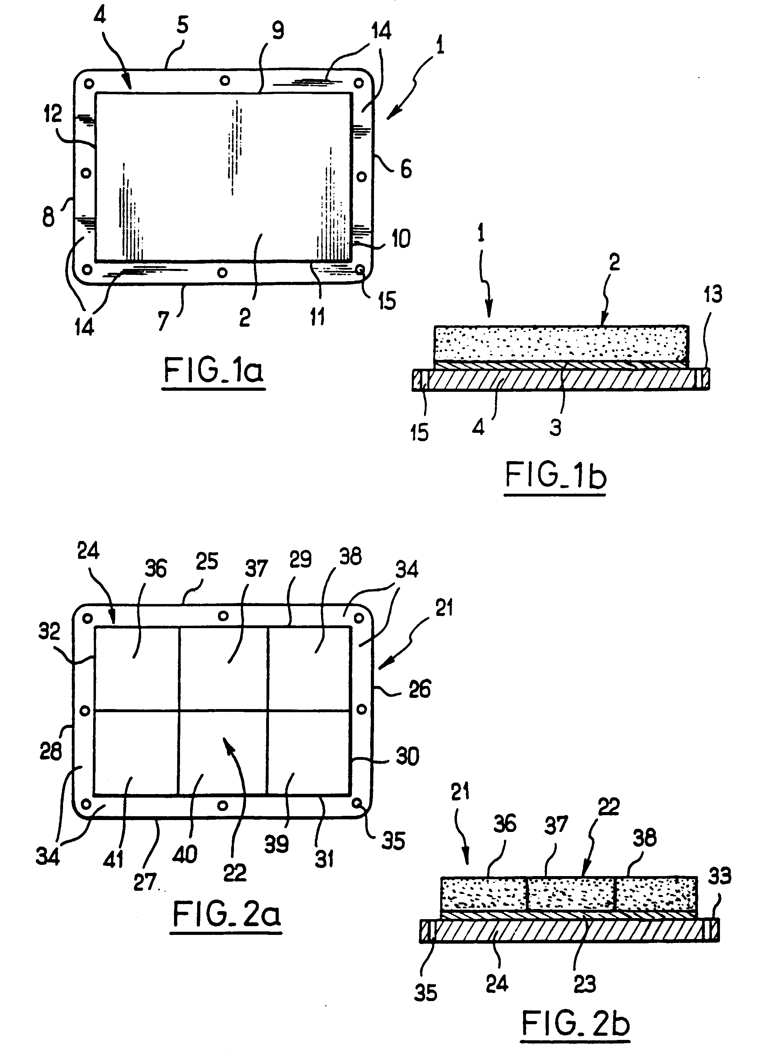

Sur le dessin annexé, les figures 1a et 1b montrent schématiquement une vue de dessus (figure la) et une coupe longitudinale (figure 1b) d'une cible de grande surface obtenue à partir d'un seul élément de cible ayant une grande surface et les figures 2a et 2b représentent schématiquement une vue de dessus (figure 2a) et une coupe longitudinale (figure 2b) d'une cible de grande surface obtenue à partir d'une pluralité d'éléments de cible de surface plus petite.

En se référant aux figures 1a et 1b, une cible 1 de grande surface comporte un élément de cible 2 de grande surface constitué d'un matériau inorganique obtenu par le procédé de l'invention. L'élément de cible 2 a la forme d'un rectangle ayant, par exemple, une longueur de 15cm et une largeur de 10cm.

L'élément 2 est solidarisé par une couche 3 d'un adhésif conducteur de la chaleur et de l'électricité, par exemple une colle conductrice époxy bicomposante renfermant de l'argent, à un substrat métallique 4 ayant des dimensions légèrement supérieures à celles de l'élément rectangulaire 2 de telle sorte que le contour formé des bords 5 à 8 du substrat métallique rectangulaire 4 entoure le contour formé des bords 9 à 12 de l'élément rectangulaire de cible 2 et lui soit parallèle, de manière à définir sur la face 13 du substrat métallique sur laquelle l'élément 2 est collé, une zone marginale 14 entourant ledit élément 2. Dans cette zone marginale débouchent des orifices tels que 15 traversant le substrat métallique et destinés au passage d'organes de fixation, par exemple vis ou autres, permettant de monter la cible 1 sur un organe support appartenant au dispositif de pulvérisation cathodique.

En se référant aux figures 2a et 2b, une cible 21 de grande surface comporte un élément de cible 22 de grande surface, qui a la forme d'un rectangle, par exemple rectangle de 15cm de longueur et de 10cm de largeur, et résulte de la juxtaposition jointive de six éléments de cible 36 à 41 ayant chacun la forme d'un carré, par exemple de 5cm de côté. Les éléments de cible 36 à 41 qui constituent l'élément de cible 22 sont solidarisés par une couche 23 d'un adhésif conducteur de la chaleur et de l'électricité, par exemple une colle conductrice époxy bicomposante renfermant de l'argent, à un substrat métallique 24 ayant des dimensions légèrement supérieures à celles de l'élément rectangulaire 22 de telle sorte que le contour formé des bords 25 à 28 du substrat métallique 24 rectangulaire entoure le contour formé des bords 29 à 32 de l'élément rectangulaire 22 et lui soit parallèle, de manière à définir sur la face 33 du substrat métallique sur laquelle les éléments de cible 36 à 41 formant l'élément 22 sont collés, une zone marginale 34 entourant ledit élément 22. Dans cette zone marginale débouchent des orifices tels que 35 traversant le substrat métallique et destinés au passage d'organes de fixation, par exemple vis ou autres, permettant de monter la cible 21 sur un organe support appartenant à un dispositif de pulvérisation cathodique. Les éléments de cible 36 à 41, dont l'assemblage jointif conduit à l'élément 22 de grande surface, sont des éléments constitués chacun d'un matériau inorganique obtenu par le procédé de l'invention en faisant appel à un support métallique lisse ou à un support non lisse en une matière facilement usinable.

L'invention est illustrée par les exemples suivants, donnés à titre non limitatif.

EXEMPLE 1 :

Elément de cible d'oxyde mixte de lithium et de nickel de composition $LiNiO_2$ et cible correspondante

On formait un système précurseur du matériau inor-ganique céramique $LiNiO_2$ en plaçant dans un mortier 7,4g de carbonate de lithium $Li_2CO_3$ et 15,2g d'oxyde de nickel NiO, lesdits carbonate et oxyde se présentant sous la forme de poudres de granulométrie comprise entre 10μm et 100μm, et en broyant le tout jusqu'à obtenir un produit homogène.

Sur un support consistant en une plaque de céramique friable constituée d'une alumine à gros grains, ladite plaque ayant la forme d'un carré de 7cm de côté et une épaisseur de 5mm, on épandait au gabarit une quantité du système précurseur pulvérulent propre à former une couche de poudre ayant la forme d'un carré de 5cm de côté et présentant une épaisseur de 5mm. L'ensemble système précurseur/support était amené depuis la température ambiante jusqu'à une température θ égale à 750°C, dans l'air atmosphérique, avec une vitesse de montée en température égale à 5°C par minute, puis il était maintenu à ladite température θ pendant une durée de 8 heures pour produire l'oxyde mixte $LiNiO_2$ à partir du système précurseur. La fusion du carbonate de lithium à la température de 732°C provoque la prise en masse du système précurseur, ce qui conduit à l'obtention d'un matériau inorganique céramique $LiNiO_2$ de haute densité. A l'issue de la durée de huit heures précitée, l'ensemble matériau inorganique/support était refroidi depuis la température θ jusqu'à la température ambiante avec une vitesse de refroidissement d'environ 5°C par minute.

Le matériau inorganique céramique $LiNiO_2$ obtenu adhérait au support. Il en était décollé mécaniquement pour former une plaquette sur l'une des faces de laquelle restaient fixés des grains du support friable. Après usinage à la meule de la face de la plaquette portant les grains de support, on obtenait une plaquette du maté-riau inorganique céramique $LiNiO_2$ formant l'élément de cible, ladite plaquette ayant la forme d'un carré de 5cm de côté et présentant une épaisseur de 4mm.

L'élément de cible, obtenu comme décrit ci-dessus, était collé sur un substrat consistant en une plaque de laiton ayant la forme d'un carré de 7cm de côté et présentant une épaisseur de lmm, à l'aide d'une colle conductrice époxy bicomposante à l'argent, de manière à laisser apparente, sur la face du substrat portant l'élément cible, une bande marginale de 1cm de largeur, dans laquelle on perçait des orifices pour le passage d'organes de fixation tels que des vis. On obtenait alors une cible ayant une structure comparable à celle schématisée sur les figures 1a et 1b, ladite cible ayant une surface utile (surface de l'élément de cible) de 25 cm$^2$.

La cible ainsi réalisée a été utilisée en pulvérisation cathodique à courant continu pour la production, avec des résultats satisfaisants, d'un dépôt mince d'oxyde de lithium et de nickel sur un substrat.

EXEMPLE 2 :

Eléments de cible d'oxyde mixte de lithium et de nickel de composition LiNiO$_2$ et cible correspondante de grande surface

En opérant comme décrit dans l'exemple 1, on préparait des éléments de cible d'oxyde mixte de lithium et de nickel de composition LiNiO$_2$ ayant chacun une surface de 25cm$^2$, lesdits éléments se présentant chacun sous la forme d'une plaquette du matériau inorganique LiNiO$_2$ ayant la forme d'un carré de 5cm de côté et présentant une épaisseur de 4mm.

Six éléments de cible obtenus étaient collés jointivement sur un substrat consistant en une plaque d'aluminium ayant la forme d'un rectangle de 17 cm de longueur et 12 cm de largeur et présentant une épaisseur de 1mm, à l'aide d'une colle conductrice époxy bicomposante renfermant de l'argent, de manière à occuper sur le substrat une surface en forme de rectangle de 15 cm de longueur et 10cm de largeur et à laisser apparente, sur la face du substrat portant les éléments de cible, une bande marginale de 1cm de largeur, dans laquelle on perçait des orifices pour le passage d'organes de fixation tels que des vis. On obtenait alors une cible de grande surface ayant une structure comparable à celle schématisée sur les figures 2a et 2b, ladite cible ayant une surface utile (surface occupée par l'ensemble des éléments de cible) égale à 150cm$^2$.

La cible ainsi réalisée a été utilisée en pulvérisation cathodique à courant continu pour produire, avec des résultats satisfaisants, un dépôt mince d'oxyde mixte de lithium et de nickel de composition LiNiO$_2$ sur un substrat.

EXEMPLE 3 :

Elément de cible de grande surface consistant en oxyde mixte de lithium et de nickel de composition LiNiO$_2$ et cible correspondante

On formait un système précurseur du matériau inorganique LiNiO$_2$ en plaçant dans un mortier 7,4 parties en poids de Li$_2$CO$_3$ et 15,2 parties en poids d'oxyde de nickel NiO, lesdits carbonate et oxyde se présentant sous la forme de poudres de granulométrie comprise entre 10μm et 100μm, et en broyant le tout jusqu'à l'obtention d'un produit homogène.

Sur un support consistant en une plaque de laiton ayant des faces lisses, ladite plaque ayant la forme d'un rectangle de 18cm de longueur et 12cm de largeur et présentant une épaisseur de lmm, on épandait au gabarit une quantité du système précurseur pulvérulent propre à former une couche de poudre ayant la forme d'un rectangle de 15cm de longueur et 10cm de largeur et présentant une épaisseur de 5mm. L'ensemble système précurseur/support était porté depuis la température ambiante jusqu'à une température θ égale à 750°C, dans l'air atmosphérique, avec une vitesse de montée en température égale à 5°C par minute, puis il était maintenu à la dite température θ pendant une durée de 5 heures pour produire l'oxyde mixte LiNiO$_2$ à partir du système précurseur. La fusion du carbonate de lithium à la température de 732°C provoquait la prise en masse du système précurseur, ce qui conduisait à l'obtention d'un matériau inorganique céramique LiNiO$_2$ de haute densité. A l'issue de la durée de 5 heures précitée, l'ensemble matériau inorganique/support était refroidi depuis la température e jusqu'à la température ambiante avec une vitesse de refroidissement d'environ 5°C par minute.

Le matériau inorganique céramique LiNiO$_2$ se décollait facilement du support lisse et l'on obtenait une plaque rectangulaire du matériau inorganique céramique LiNiO$_2$ formant l'élément de cible de grande surface, ladite plaque ayant la forme d'un rectangle de 15 cm de longueur et 10 cm de largeur et présentant une épaisseur de 4 mm.

L'élément de cible obtenu était collé sur un substrat consistant en une plaque d'aluminium ayant la forme d'un rectangle de 17cm de longueur et 12 cm de largeur et présentant une épaisseur de 1mm, à l'aide d'une colle conductrice époxy bicomposante renfermant de l'argent, de manière à occuper sur le substrat une surface en forme de rectangle de 15cm de longueur et 10cm de largeur et à laisser apparente, sur la face du substrat portant l'élément de cible, une bande marginale de 1cm de largeur, dans laquelle on perçait des orifices pour le passage d'organes de fixation tels que des vis. On obtenait ainsi une cible de grande surface ayant une structure comparable à celle schématisée sur les figures 1a et 1b, ladite cible ayant une surface utile (surface occupée par l'élément de cible) égale à 150cm$^2$.

La cible ainsi réalisée a été utilisée en pulvérisation cathodique à courant continu pour produire, avec des résultats satisfaisants, un dépôt mince d'oxyde mixte de LiNiO$_2$ sur un substrat.

EXEMPLE 4 :

Eléments de cible d'oxyde mixte de lithium et de tungstène et cible correspondante de grande surface

On préparait des éléments de cible d'oxyde mixte de lithium et de tungstène en opérant comme décrit dans l'exemple 1 avec toutefois remplacement de l'oxyde de nickel NiO par la même quantité molaire d'oxyde de tungstène $WO_3$.

A la fin des opérations, après séparation d'avec le support et usinage à la meule, on obtenait des plaquettes de matériau inorganique céramique consistant en oxyde mixte de lithium et de tungstène et formant des éléments de cible selon l'invention, chaque plaquette ayant la forme d'un carré de 5cm de côté et présentant une épaisseur de 4mm.

Six éléments de cible ainsi obtenus étaient collés comme indiqué dans l'exemple 2 sur un substrat consistant en une plaque d'aluminium ayant la forme d'un rectangle de 17cm de longueur et 12cm de largeur et présentant une épaisseur de 1mm pour former une cible de grande surface ayant une structure comparable à celle schématisée sur les figures 2a et 2b, ladite cible ayant une surface utile (surface occupée par l'ensemble des éléments de cible) égale à $150cm^2$.

La cible réalisée a été utilisée en pulvérisation cathodique pour produire, avec des résultats satisfaisants, un dépôt mince d'oxyde mixte de lithium et de tungstène sur un substrat.

EXEMPLE 5 :

Elément de cible de grande surface consistant en oxyde mixte de lithium et de tungstène et cible correspondante

On préparait un élément de cible de grande surface consistant en oxyde mixte de lithium et de tungstène en opérant comme décrit dans l'exemple 3 avec toutefois remplacement de l'oxyde de nickel NiO par la même quantité molaire d'oxyde de tungstène $WO_3$

A la fin des opérations, après séparation d'avec le support, on obtenait une plaque de matériau inorganique céramique consistant en oxyde mixte de lithium et de tungstène, ladite plaque formant un élément de cible de grande surface selon l'invention. Cette plaque avait une longueur de 15cm et une largeur de 10cm et présentait une épaisseur de 4mm.

L'élément de cible de grande surface obtenu était collé comme décrit dans l'exemple 3 sur un substrat consistant en une plaque d'aluminium ayant la forme d'un rectangle de 17cm de longueur et 12cm de largeur et présentant une épaisseur de 1mm pour former une cible de grande surface ayant une structure comparable à celle schématisée sur les figures 1a et 1b, ladite cible ayant une surface utile (surface occupée par l'élément de cible) égale à $150cm^2$.

La cible ainsi réalisée a été utilisée en pulvérisation cathodique pour produire, avec des résultats satisfaisants, un dépôt mince d'oxyde mixte de lithium et de tungstène sur un substrat.

**Revendications**

1.  Procédé pour la préparation d'un élément de cible pour pulvérisation cathodique en un matériau inorganique céramique possédant un point de fusion supérieur à 300°C et ayant la formule d'un oxyde, sulfure,halogénure ou oxyhalogénure d'un ou plusieurs métaux, selon lequel on constitue un système précurseur du matériau inorganique susceptible de donner naissance audit matériau à des températures θ comprises entre 300°C et 1600°C et inférieures au point de fusion de ce matériau, ledit système précurseur renfermant au moins 20% molaire d'un adjuvant inorganique consistant en au moins un composé inorganique ayant un point de fusion inférieur ou égal à la température θ choisie pour la production du matériau inorganique, on forme une couche dudit système précurseur sur un support, qui est sensiblement inerte vis à vis du système précurseur et du matériau inorganique céramique à produire et qui est thermiquement et mécaniquement stable jusqu'à des températures supérieures à θ, à l'exclusion d'un support en mousse ou feutre métallique, on porte l'ensemble support/système précurseur à la température θ choisie pour produire le matériau inorganique, avec une vitesse de montée en température propre à éviter la formation de dendrites, puis on maintient ledit ensemble à cette température θ pendant une durée suffisante pour transformer le système précurseur en ledit matériau inorganique céramique, et on refroidit ensuite l'ensemble support/matériau inorganique pour le ramener à température ambiante en réalisant ce refroidissement de manière à éviter tout phénomène de trempe.

2.  Procédé selon la revendication 1, caractérisé en ce que le matériau inorganique répond à l'une ou l'autre des formules $E_\alpha{}^k Z_\beta{}^p$ et $M_x{}^q T_y{}^n Z_z{}^p$, dans lesquelles E représente au moins un métal des groupes I à VIII du Tableau Périodique des Eléments,M et T désignent chacun un métal différent des groupes I à VIII dudit Tableau Périodique, Z est au moins un élément choisi parmi oxygène, soufre, fluor et chlore, les symboles k, q, n et p désignent les degrés d'oxydation moyens des éléments E, M, T et Z respectivement, α et β désignent des nombres entiers positifs tels que $\alpha k + \beta p = O$ et x, y et z désignent des nombres entiers positifs tels que $qx + ny + pz = O$.

3.  Procédé selon la revendication 1, caractérisé en ce que le matériau inorganique est un oxyde répon

dant à l'une ou l'autre des formules $E_\alpha{}^k O_\beta{}^{2-}$ et $M_x{}^q T_y{}^n O_z{}^{2-}$, dans lesquelles E est au moins un métal des groupes I à VIII du Tableau Périodique des Eléments, M et T désignent chacun un métal différents dudit Tableau Périodique, les symboles k, q et n désignent les degrés d'oxydation moyens de E, M et T respectivement, $\alpha$ et $\beta$ sont des nombres entiers positifs tels que $\alpha k - 2\beta = 0$ et x, y et z désignent des nombres entiers positifs tels que $qx + ny - 2z = 0$.

4. Procédé selon la revendication 2 ou 3, caractérisé en ce que E représente au moins un métal choisi parmi Fe, Cu, Co, Ni, Ti, Cr, Mo, W, Sn et In, M désigne un métal choisi parmi Li, Na, K, Ag, Cu et Tl et T représente un métal choisi parmi Ni, Co, W, Mn, Fe, Cr, V et Ti.

5. Procédé selon l'une des revendications 1 à 4, caractérisé en ce que le système précurseur du matériau inorganique renferme le matériau inorganique lui-même.

6. Procédé selon la revendication 2 ou 5, caractérisé en ce que le matériau inorganique répond à la formule $E_\alpha{}^k Z_\beta{}^p$ et en ce que le système précurseur du matériau inorganique renferme ledit matériau lui-même.

7. Procédé selon la revendication 4 ou 5, caractérisé en ce que le matériau inorganique répond à la formule $E_\alpha{}^k O_\beta{}^{2-}$ et en ce que le système précurseur du matériau inorganique renferme ledit matériau lui-même.

8. Procédé selon l'une des revendications 1 à 4, caractérisé en ce que le système précurseur du matériau inorganique est formé d'un mélange d'ingrédients conduisant, par réaction chimique à des températures inférieures ou égales à $\theta$, au matériau inorganique envisagé.

9. Procédé selon la revendication 2 ou 4, caractérisé en ce que le matériau inorganique répond à la formule $M_x{}^q T_y{}^n Z_z{}^p$ et en ce que le système précurseur du matériau inorganique consiste en un mélange renfermant, en proportions appropriées, au moins un composé de métal M et au moins un composé de métal T, qui sont susceptibles de former le matériau inorganique $M_x{}^q T_y{}^n Z_z{}^p$ à la température $\theta$.

10. Procédé selon la revendication 3 ou 4, caractérisé en ce que le matériau inorganique répond à la formule $M_x{}^q T_y{}^n O_z{}^{2-}$ et en ce que le système précurseur du matériau inorganique consiste en un mélange renfermant, en proportions appropriées, au moins un composé de métal M et au moins un composé de métal T, qui sont susceptibles de former le matériau inorganique $M_x{}^q T_y{}^n O_z{}^{2-}$ à la température

$\theta$.

11. Procédé selon la revendication 10, caractérisé en ce que le système précurseur du matériau inorganique consiste en un mélange renfermant au moins un carbonate de métal M de formule

$$M_x{}^q (CO_3)_{\frac{qx}{2}}$$

et au moins un oxyde de métal T de formule

$$T^n O^{2-}{}_{\frac{ny}{2}}.$$

12. Procédé selon l'une des revendications 1 à 11, caractérisé en ce que l'adjuvant inorganique est choisi parmi les fluorures, chlorures et carbonates des métaux alcalins.

13. Procédé selon la revendication 12, caractérisé en ce que l'adjuvant inorganique est choisi parmi les fluorures, chlorures et carbonates de lithium, sodium ou potassium.

14. Procédé selon l'une des revendications 8 à 11, caractérisé en ce que dans le système précurseur renfermant un mélange d'ingrédients réagissant chimiquement à la température $\theta$ pour former le matériau inorganique, l'un desdits ingrédients a une température de fusion inférieure ou égale à $\theta$, ledit ingrédient constituant alors l'adjuvant inorganique présent dans le système précurseur.

15. Procédé selon la revendication 11, caractérisé en ce que le système précurseur du matériau inorganique consiste en un mélange constitué d'au moins un carbonate de métal M de formule

$$M_x{}^q (CO_3)_{\frac{qx}{2}}$$

avec M représentant un métal alcalin, notamment Li, Na ou K, et d'au moins un oxyde de métal T de formule $T_y{}^n O_{ny/2}{}^{2-}$, ledit carbonate constituant l'adjuvant inorganique présent dans le système précurseur et en ce que la température $\theta$ est comprise entre le point de fusion du carbonate de métal M et 1600°C.

16. Procédé selon la revendication 15, caractérisé en ce que le carbonate du système précurseur est le carbonate de lithium $Li_2CO_3$ et en ce que la température $\theta$ est comprise entre 723°C et 1600°C.

**17.** Procédé selon l'une des revendications 1 à 16, caractérisé en ce que le système précurseur du matériau inorganique renferme entre 20% et 80% molaire de l'adjuvant inorganique.

**18.** Procédé selon l'une des revendications 1 à 17, caractérisé en ce que le système précurseur du matériau inorganique se présente sous la forme d'une poudre de granulométrie appropriée et en ce que l'application dudit système précurseur sur le support est effectuée par saupoudrage dudit support au moyen de cette poudre.

**19.** Procédé selon l'une des revendications 1 à 17, caractérisé en ce que le système précurseur du matériau inorganique se présente sous la forme d'une pâte d'enduction, obtenue en mélangeant le système précurseur en poudre avec un ou plusieurs liquides tels que l'eau ou un liquide organique, ou bien sous la forme d'un gel, obtenu à partir du système précurseur pulvérulent par une technique sol/gel, et en ce que l'application du système précurseur sur le support est effectuée par enduction au moyen de ladite pâte ou dudit gel.

**20.** Procédé selon la revendication 19, caractérisé en ce que l'ensemble issu de l'enduction du support par la pâte ou le gel est soumis à une étape de séchage avant la phase de montée en température pour atteindre la température θ.

**21.** Procédé selon l'une des revendications 1 à 20, caractérisé en ce que la température θ, que l'on choisit pour produire ledit matériau inorganique à partir du système précurseur renfermant l'adjuvant inorganique, est choisie entre 600°C et 1200°C.

**22.** Procédé selon l'une des revendications 1 à 21, caractérisé en ce que la vitesse de montée en température pour atteindre la température θ est comprise entre 0,05°C et 20°C par minute

**23.** Procédé selon la revendication 22, caractérisé en ce que ladite vitesse de montée en température est comprise entre 0,1°C et 10°C par minute.

**24.** Procédé selon l'une des revendications 1 à 23, caractérisé en ce que la durée de maintien de l'ensemble système précurseur/support à la température θ est comprise entre 30 minutes et 20 heures.

**25.** Procédé selon l'une des revendications 1 à 24, caractérisé en ce que le refroidissement de l'ensemble matériau inorganique/support depuis la température θ jusqu'à l'ambiante est réalisé avec des vitesses de refroidissement allant de 0,05°C à 20°C par minute

**26.** Procédé selon la revendication 25, caractérisé en ce que lesdites vitesses de refroidissement vont de 0,1°C à 10°C par minute.

**27.** Procédé selon l'une des revendications 1 à 26, caractérisé en ce que le support utilisé est un support en un métal ou alliage métallique, à l'exclusion de tout support en mousse ou feutre métallique, ou un support en une matière céramique.

**28.** Procédé selon la revendication 27, caractérisé en ce que ledit support est en platine, laiton, titane, nickel, cuivre ou acier inoxydable.

**29.** Procédé selon l'une des revendications 1 à 28, caractérisé en ce que l'on utilise un support lisse, par exemple un support métallique lisse, et l'on sépare le matériau inorganique constituant l'élément de cible d'avec le support.

**30.** Procédé selon l'une des revendications 1 à 28, caractérisé en ce que l'on utilise un support non lisse en un matériau facilement usinable et l'on sépare mécaniquement le matériau inorganique constituant l'élément de cible d'avec le support et soumet à un usinage la face dudit élément de cible qui était en contact avec le support.

**31.** Procédé selon l'une des revendications 1 à 28, caractérisé en ce que l'on utilise un support rugueux, de telle sorte que le matériau inorganique reste solidaire du support, de manière à former un élément de cible supporte constituant une cible pour pulvérisation cathodique.

**32.** Procédé selon la revendication 29 ou 30, caractérisé en ce que l'élément de cible (2,22) est associé à un substrat (4,24) pour constituer une cible pour pulvérisation cathodique.

**33.** Procédé selon la revendication 29 ou 30, caractérisé en ce que l'élément de cible (2,22) est collé sur un substrat métallique (4,24)au moyen d'un adhésif (3,23) conducteur de la chaleur et de l'électricité, pour constituer une cible pour pulvérisation cathodique.

**34.** Procédé selon la revendication 33, caractérisé en ce que ledit substrat métallique est en laiton , aluminium, cuivre, titane, tungstène ou acier inoxydable.

**35.** Procédé selon la revendication 33 ou 34, caractérisé en ce que ledit adhésif est un adhésif consistant en une colle conductrice époxy bicomposante renfermant de l'argent.

**36.** Procédé selon l'une des revendications 33 à 35, caractérisé en ce que l'élément de cible a une surface de l'ordre de 100cm$^2$ à 1m$^2$ et le substrat métallique associé à une surface correspondante.

37. Procédé selon l'une des revendications 33 à 35, caractérisé en ce que sur un substrat métallique ayant une surface donnée de l'ordre de 100cm$^2$ à 1m$^2$, on colle une pluralité d'éléments de cible, ayant chacun une surface inférieure à ladite surface donnée, de telle sorte que lesdits éléments soient disposés de manière jointive sur ledit substrat et couvre ladite surface donnée du substrat.

38. Procédé selon l'une des revendications 33 à 37, caractérisé en ce que l'on réalise le collage de l'élément de cible ou de la pluralité d'éléments de cible sur le substrat métallique de manière à définir, sur la face du substrat métallique sur laquelle le ou les éléments de cible sont collés, une zone marginale (14,34) entourant l'élément de cible (2) ou la pluralité d'éléments de cible jointifs (22).

**Patentansprüche**

1. Verfahren zur Herstellung eines Targetelements zur kathodischen Zerstäubung aus einem keramischen anorganischen Material mit einem Schmelzpunkt von über 300°C und mit der Formel eines Oxids, Sulfids, Halogenids oder Oxidhalogenids eines oder mehrerer Metalle, bei dem man ein Vorstufensystem des anorganisches Materials bildet, das dieses Material bei einer Temperatur θ zwischen 300 und 1600°C und unterhalb seines Schmelzpunktes zu bilden vermag, wobei das Vorstufensystem wenigstens 20 Mol-% eines anorganischen Zusatzes enthält, der in wenigstens einer anorganischen Verbindung mit einem Schmelzpunkt, der unterhalb der für die Herstellung des anorganischen Materials gewählten Temperatur θ liegt oder dieser entspricht, besteht, man eine Schicht des Vorstufensystems auf einem Träger ausbildet, der gegenüber dem Vorstufensystem und dem herzustellenden keramischen anorganischen Material annähernd inert ist und der bis auf Temperaturen von über θ thermisch und mechanisch beständig ist, unter Ausschluß eines Trägers aus Metallschwamm oder -filz, man die Gesamtheit aus Träger und Vorstufensystem auf die für die Erzeugung des anorganischen Materials gewählte Temperatur θ mit einer Geschwindigkeit des Temperaturanstiegs erwärmt, die geeignet ist, die Bildung von Dendriten zu verhindern, man dann das Ganze bei dieser Temperatur θ während einer für die Umwandlung des Vorstufensystems in das keramische anorganische Material ausreichenden Zeitdauer hält und man schließlich die Gesamtheit aus Träger und anorganischem Material auf Umgebungstemperatur abkühlt, wobei man die Abkühlung so durchführt, daß jedwede Abschreckung vermieden wird.

2. Verfahren nach Anspruch 1, dadurch **gekennzeichnet,** daß das anorganische Material einer der Formeln $E_\alpha{}^k Z_\beta{}^p$ und $M_x{}^q T_y{}^n Z_z{}^p$ entspricht, wobei E wenigstens ein Metall der Gruppen I bis VIII des Periodensystems, M und T jeweils ein anderes Metall der Gruppen I bis VIII des Periodensystems, Z wenigstens ein Element, ausgewählt unter Sauerstoff, Schwefel, Fluor und Chlor, die Symbole k, q, n und p die durchschnittlichen Oxidationsstufen der Elemente E, M, T und Z, $\alpha$ und $\beta$ ganze positive Zahlen wie $\alpha k + \beta p = 0$ sowie x, y und z ganze positive Zahlen wie $qx + ny + pz = 0$ bedeuten.

3. Verfahren nach Anspruch 1, dadurch **gekennzeichnet,** daß das anorganische Material ein Oxid einer der Formeln $E_\alpha{}^k O_\beta{}^{2-}$ und $M_x{}^q T_y{}^n O_z{}^{2-}$ entspricht, wobei E wenigstens ein Metall der Gruppen I bis VIII des Periodensystems, M und T jeweils ein anderes Metall des Periodensystems, die Symbole k, q und n die durchschnittlichen Oxidationsstufen von E, M und T, $\alpha$ und $\beta$ ganze positive Zahlen wie $\alpha k - 2\beta = 0$ und x, y und z ganze positive Zahlen wie $qx + ny - 2z = 0$ bedeuten.

4. Verfahren nach Anspruch 2 oder 3, dadurch **gekennzeichnet,** daß E wenigstens ein Metall, ausgewählt unter Fe, Cu, Co, Ni, Ti, Cr, Mo, W, Sn und In, M ein Metall, ausgewählt unter Li, Na, K, Ag, Cu und Tl, und T ein Metall, ausgewählt unter Ni, Co, W, Mn, Fe, Cr, V und Ti, bedeuten.

5. Verfahren nach einem der Ansprüche 1 bis 4, dadurch **gekennzeichnet,** daß das Vorstufensystem des anorganischen Materials das anorganische Material selbst enthält.

6. Verfahren nach Anspruch 2 oder 5, dadurch **gekennzeichnet,** daß das anorganische Material der Formel $E_\alpha{}^k Z_\beta{}^p$ entspricht und das Vorstufensystem des anorganischen Materials das anorganische Material selbst enthält.

7. Verfahren nach Anspruch 4 oder 5, dadurch **gekennzeichnet,** daß das anorganische Material der Formel $E_\alpha{}^k O_\beta{}^{2-}$ entspricht und das Vorstufensystem des anorganischen Materials das anorganische Material selbst enthält.

8. Verfahren nach einem der Ansprüche 1 bis 4, dadurch **gekennzeichnet,** daß das Vorstufensystem des anorganischen Materials aus einem Komponentengemisch gebildet wird, das durch chemische Umsetzung bei Temperaturen unterhalb θ oder bei dieser Temperatur zum erwünschten anorgani-

9. Verfahren nach Anspruch 2 oder 4, dadurch **gekennzeichnet,** daß das anorganische Material der Formel $M_x^q T_y^n Z_z^p$ entspricht und das Vorstufensystem des anorganischen Materials aus einem Gemisch besteht, das in geeigneten Mengen wenigstens eine Verbindung des Metalls M und wenigstens eine Verbindung des Metalls T, die das anorganische Material $M_x^q T_y^n Z_z^p$ bei der Temperatur $\theta$ zu bilden vermögen, enthält.

10. Verfahren nach Anspruch 3 oder 4, dadurch **gekennzeichnet,** daß das anorganische Material der Formel $M_x^q T_y^n O_z^{2-}$ entspricht und das Vorstufensystem des anorganischen Materials aus einem Gemisch besteht, das in geeigneten Mengen wenigstens eine Verbindung des Metalls M und wenigstens eine Verbindung des Metalls T, die das anorganische Material $M_x^q T_y^n O_z^{2-}$ bei der Temperatur $\theta$ zu bilden vermögen, enthält.

11. Verfahren nach Anspruch 10, dadurch **gekennzeichnet,** daß das Vorstufensystem des anorganischen Materials aus einem Gemisch besteht, das wenigstens ein Carbonat des Metalls M der Formel $M_x^q (CO_3)_{qx/2}$ und wenigstens ein Oxid des Metalls T der Formel $T^n O^{2-}_{ny/2}$ enthält.

12. Verfahren nach einem der Ansprüche 1 bis 11, dadurch **gekennzeichnet,** daß der anorganische Zusatz unter Alkalimetallfluoriden, -chloriden und -carbonaten ausgewählt wird.

13. Verfahren nach Anspruch 12, dadurch **gekennzeichnet**, daß der anorganische Zusatz unter Fluoriden, Chloriden und Carbonaten von Lithium, Natrium oder Kalium ausgewählt wird.

14. Verfahren nach einem der Ansprüche 8 bis 11, dadurch **gekennzeichnet,** daß im Vorstufensystem, das ein Gemisch aus Komponenten enthält, die bei der Temperatur $\theta$ chemisch reagieren, um das anorganische Material zu bilden, eine der Komponenten eine Schmelztemperatur aufweist, die unterhalb $\theta$ liegt oder dieser Temperatur entspricht, wobei diese Komponente dann den im Vorstufensystem vorliegenden anorganischen Zusatz bildet.

15. Verfahren nach Anspruch 11, dadurch **gekennzeichnet,** daß das Vorstufensystem des anorganischen Materials aus einem Gemisch besteht, das aus wenigstens einem Carbonat des Metalls M der Formel $M_x^q (CO_3)_{qx/2}$, wobei M ein Alkalimetall, wie z.B. Li, Na oder K darstellt, und aus wenigstens einem Oxid des Metalls T der Formel $T_y^n O_{ny/2}^{2-}$ zusammengesetzt ist, wobei das Carbonat den im Vorstufensystem vorliegenden anorganischen Zusatz bildet und die Temperatur $\theta$ zwischen dem Schmelzpunkt des Carbonats des Metalls und 1600°C liegt.

16. Verfahren nach Anspruch 15, dadurch **gekennzeichnet,** daß das Carbonat des Vorstufensystems Lithiumcarbonat ($Li_2CO_3$) ist und die Temperatur $\theta$ zwischen 723°C und 1600°C liegt.

17. Verfahren nach einem der Ansprüche 1 bis 16, dadurch **gekennzeichnet,** daß das Vorstufensystem des anorganischen Materials 20 bis 80 Mol.-% anorganischen Zusatz enthält.

18. Verfahren nach einem der Ansprüche 1 bis 17, dadurch **gekennzeichnet,** daß das Vorstufensystem des anorganischen Materials in Form eines Pulvers in geeigneter Granulometrie vorliegt und die Aufbringung des Vorstufensystems auf den Träger durch Bepudern des Trägers mit dem Pulver erfolgt.

19. Verfahren nach einem der Ansprüche 1 bis 17, dadurch **gekennzeichnet,** daß das Vorstufensystem des anorganischen Materials in Form einer Streichmasse, die man durch Mischen des Vorstufensystems in Pulverform mit einer oder mehreren Flüssigkeiten wie Wasser oder einer organischen Flüssigkeit erhält, oder in Form eines Gels, das man aus einem pulverförmigen Vorstufensystem durch eine Sol-Gel-Technik erhält, vorliegt, und daß die Aufbringung des Vorstufensystems auf den Träger durch Bestreichen mit der Masse oder dem Gel erfolgt.

20. Verfahren nach Anspruch 19, dadurch **gekennzeichnet**, daß der durch Bestreichen des Trägers mit der Masse oder dem Gel erhaltene Körper vor der Phase des Temperaturanstiegs zur Erreichung der Temperatur $\theta$ einer Trocknungsstufe unterworfen wird.

21. Verfahren nach einem der Ansprüche 1 bis 20, dadurch **gekennzeichnet,** daß die Temperatur $\theta$, die man wählt, um aus dem den anorganischen Zusatz enthaltenden Vorstufensystem das anorganische Material zu erzeugen, zwischen 600°C und 1200°C gewählt wird.

22. Verfahren nach einem der Ansprüche 1 bis 21, dadurch **gekennzeichnet,** daß die Geschwindigkeit des Temperaturanstiegs zur Erreichung der Temperatur $\theta$ 0,05°C bis 20°C/min beträgt.

23. Verfahren nach Anspruch 22, dadurch **gekennzeichnet,** daß die Geschwindigkeit des Temperaturanstiegs 0,1°C bis 10°C/min beträgt.

24. Verfahren nach einem der Ansprüche 1 bis 23, dadurch **gekennzeichnet,** daß die Dauer des Haltens der Gesamtheit aus Vorstufensystem und Träger bei der Temperatur θ zwischen 30 Minuten und 20 Stunden beträgt.

25. Verfahren nach einem der Ansprüche 1 bis 24, dadurch **gekennzeichnet,** daß die Abkühlung der Gesamtheit aus organischem Material und Träger von der Temperatur θ auf Umgebungstemperatur bei einer Geschwindigkeit von 0,05°C bis 20°C/min erfolgt.

26. Verfahren nach Anspruch 25, dadurch **gekennzeichnet,** daß die Abkühlungsgeschwindigkeit 0,1°C bis 10°C/min beträgt.

27. Verfahren nach einem der Ansprüche 1 bis 26, dadurch **gekennzeichnet,** daß der verwendete Träger ein Träger aus einem Metall oder einer Metalllegierung unter Ausschluß von Trägern aus Metallschwamm oder -filz oder ein Träger aus einem keramischen Stoff ist.

28. Verfahren nach Anspruch 27, dadurch **gekennzeichnet,** daß der Träger aus Platin, Messing, Titan, Nickel, Kupfer oder nichtrostendem Stahl besteht.

29. Verfahren nach einem der Ansprüche 1 bis 28, dadurch **gekennzeichnet,** daß man einen glatten Träger wie zum Beispiel einen glatten Metallträger verwendet und daß man das das Targetelement bildende anorganische Material vom Träger trennt.

30. Verfahren nach einem der Ansprüche 1 bis 28, dadurch **gekennzeichnet,** daß man einen nicht glatten Träger aus leicht bearbeitbarem Werkstoff verwendet und daß man das das Targetelement bildende anorganische Material mechanisch vom Träger trennt und man die Fläche des Targetelements, die mit dem Träger in Berührung stand, spanabhebend bearbeitet.

31. Verfahren nach einem der Ansprüche 1 bis 28, dadurch **gekennzeichnet,** daß man einen rauhen Träger verwendet, so daß das anorganische Material mit dem Träger fest verbunden bleibt, um ein auf einem Träger befindliches Targetelement zu bilden, das ein Target für die kathodische Zerstäubung abgibt.

32. Verfahren nach Anspruch 29 oder 30, dadurch **gekennzeichnet,** daß das Targetelement (2,22) mit einem Substrat (4,24) verbunden ist, um ein Target für die kathodische Zerstäubung zu bilden.

33. Verfahren nach Anspruch 29 oder 30, dadurch **gekennzeichnet,** daß das Targetelement (2,22) auf ein Metallsubstrat (4,24) mit Hilfe eines wärme- und stromleitenden Klebstoffs (3,23) aufgeklebt wird, um ein Target für die kathodische Zerstäubung zu bilden.

34. Verfahren nach Anspruch 33, dadurch **gekennzeichnet,** daß das Metallsubstrat aus Messing, Aluminium, Kupfer, Titan, Wolfram oder nichtrostendem Stahl besteht.

35. Verfahren nach Anspruch 33 oder 34, dadurch **gekennzeichnet,** daß der Klebstoff ein Klebstoff ist, der in einem Silber enthaltenden, leitenden Epoxid-Zweikomponentenkleber besteht.

36. Verfahren nach einem der Ansprüche 33 bis 35, dadurch **gekennzeichnet,** daß das Targetelement eine Oberfläche in der Größenordnung von 100 cm$^2$ bis 1 m$^2$ hat und das damit verbundene Metallsubstrat eine entsprechende Oberfläche hat.

37. Verfahren nach einem der Ansprüche 33 bis 35, dadurch **gekennzeichnet,** daß man auf ein Metallsubstrat mit einer gegebenen Oberfläche in der Größenordnung von 100 cm$^2$ bis 1 m$^2$ eine Vielzahl von Targetelementen aufklebt, von denen jedes eines Oberfläche aufweist, die geringer als die gegebene Oberfläche ist, so daß die Elemente aneinanderstoßend auf dem Substrat angeordnet sind und die gegebene Oberfläche des Substrats bedecken.

38. Verfahren nach einem der Ansprüche 33 bis 37, dadurch **gekennzeichnet,** daß man das Targetelement oder die Vielzahl von Targetelementen auf dem Metallsubstrat so aufklebt, daß auf der Fläche des Metallsubstrats, auf das das Targetelement aufgeklebt ist bzw. die Targetelemente aufgeklebt sind, eine Randzone (14,34) abgegrenzt wird, welche das Targetelement (2) oder die Vielzahl der aneinanderstoßenden Targetelemente (22) umgibt.

## Claims

1. Process for the preparation of a target element for cathode sputtering of an inorganic ceramic material having a melting point of greater than 300° C and having the formula of an oxide, sulphide, halide, or oxyhalide of one or several metals, according to which a precursor system of inorganic material capable of giving rise to said material at temperatures 0 of between 300°C and 1600°C and less than the melting point of this material is formed, said precursor system containing at least 20 mole % of an inorganic additive consisting of a least one inorganic compound having a melting point of less than or equal to the temperature 0 selected for the production of the inorganic material, a layer is formed of said precursor system on a support, which is substantially inert in relation to the precursor system and of the ceramic inorganic material to be produced and which is thermally and mechanically stable up to temperatures of greater than 0, to the exclusion of a support of metal foam or metal felt, the support/precursor system assembly is brought to the temperature 0 selected for the production of the inorganic material with a rate of increase in temperature suitable for avoiding the formation of dendrites, then said assembly is retained at this temperature 0 for a sufficient duration to transform the precursor system into said ceramic inorganic material, and said support/inorganic material assembly is subsequently cooled to bring it to an ambient temperature by performing this cooling in such a manner as to avoid any phenomenon of quench-hardening.

2. Process according to claim 1, characterised in that the inorganic material corresponds to one or other of the formulae $E_\alpha^k Z_\beta^p$ and $M_x^q T_y^n Z_z^p$, in which E represents at least one metal of the groups I to VIII of the Periodic Table of Elements, M and T each designating a different metal of the groups I to VIII of said Periodic Table, Z being at least one element selected from among oxygen, sulphur, fluorine and chlorine, the symbols k, q, n and p designating the average oxidation levels of the elements E, M, T and Z respectively, $\alpha$ and $\beta$ designating positive integers such that $\alpha k + \beta p = O$ and x, y, and z designate positive integers such as $qx + ny + pz = O$.

3. Process according to claim 1, characterised in that the inorganic material is an oxide corresponding to one or other of the formulae $E_\alpha^k O_\beta^{2-}$ and $M_x^q T_y^n O_z^{2-}$, in which E is at least one metal of groups I to VIII of the Periodic Table of Elements, M and T each designating a different metal of said Periodic Table, the symbols k, q and n designating the average oxidation levels of E, M and T respectively, a and $\beta$ being positive integers such that $\alpha k - 2\beta = O$ and x, y and z designating positive integers such that $qx + ny - 2z = O$.

4. Process according to Claims 2 or 3, characterised in that E represents at least one metal selected from among Fe, Cu, Co, Ni, Ti, Cr, Mo, W, Sn and In, M designates a metal selected from among Li, Na, K, Ag, Cu and Tl and T represents a metal selected from among Ni, Co, W, Mn, Fe, Cr, V and Ti.

5. Process according to one of Claims 1 to 4, characterised in that the precursor system of the inorganic material contains the inorganic material itself.

6. Process according to Claims 2 or 5, characterised in that the inorganic material corresponds to the formula $E_\alpha^k Z_\beta^p$ and in that the inorganic system which is the precursor of the inorganic material contains said material itself.

7. Process according to claim 4 or 5, characterised in that the inorganic material corresponds to the formula $E_\alpha^k O_\beta^{2-}$ and in that the precursor system of inorganic material contains said material itself.

8. Process according to any one of Claims 1 to 4, characterised in that the precursor system of inorganic material is formed of a mixture of ingredients leading, by chemical reaction to temperatures of less than or equal to $\theta$, to the envisaged inorganic material.

9. Process according to Claims 2 or 4, characterised in that the inorganic material corresponds to the formula $M_x^q T_y^n Z_z^p$ and in that the precursor system of the inorganic material consists in a mixture containing, in suitable proportions, at least one compound of the metal M and at least one compound of the metal T, which are capable of forming the inorganic material $M_x^q T_y^n Z_z^p$ at the temperature $\theta$.

10. Process according to Claims 3 or 4, characterised in that the inorganic material corresponds to the formula $M_x^q T_y^n O_z^{2-}$ and in that the precursor system of the inorganic material consists in a mixture containing, in suitable proportions, at least one compound of the metal M and at least one compound of the metal T, which are capable of forming the inorganic material $M_x^q T_y^n O_z^{2-}$ at the temperature $\theta$.

11. Process according to Claim 10, characterised in that the precursor system of inorganic material consists of a mixture containing at least one carbonate of metal M of the formula $M_x^q (CO_3)_{qx/2}$ and at least one oxide of metal T of the formula $T^n O^{2-}_{ny/2}$.

12. Process according to one of Claims 1 to 11, characterised in that the inorganic additive is selected from among fluorides, chlorides and carbonates of alkali metals.

13. Process according to Claim 12, characterised in that the inorganic additive is selected from among fluorides, chlorides and carbonates of lithium, sodium or potassium.

14. Process according to any one of Claims 8 to 11, characterised in that, in the precursor system containing a mixture of ingredients reacting chemically at the temperature $\theta$ to form the inorganic material, one of said ingredients has a melting temperature of less than or equal to $\theta$ said ingredient thus forming the inorganic additive which is present in the precursor system.

15. Process according to Claim 11, characterised in that the precursor system of the inorganic material consists of a mixture formed of at least one carbonate of metal M of the formula $M_x^q(CO_3)_{qx/2}$ where M represents an alkali metal, in particular Li, Na or K, and at least one oxide of metal T of the formula $T_y^nO^{2-}_{ny/2}$, said carbonate forming the inorganic additive present in the precursor system and in that the temperature θ is comprised between the melting point of the metal carbonate M and 1600°C.

16. Process according to Claim 15, characterised in that the carbonate of the precursor system is lithium carbonate $Li_2CO_3$ and in that the temperature θ is between 723°C and 1600°C.

17. Process according to Claims 1 to 16, characterised in that the precursor system of the inorganic material contains between 20 and 80 molar % of the inorganic additive.

18. Process according to any one of Claims 1 to 17, characterised in that the precursor system of the inorganic material is present in the form of a powder of suitable particle size, and in that the application of said precursor system on the support is performed by dusting said support with this powder.

19. Process according to one of Claims 1 to 17 characterised in that the precursor system of the inorganic material is present in the form of a coating paste, obtained by mixing the precursor system in powder with one or several liquids such as water or an organic liquid, or even in the form of a gel, obtained from a powdered precursor system by a sol/gel method, and in that the application of the precursor onto the support is performed by coating by means of said paste or said gel.

20. Process according to Claim 19, characterised in that the product resulting from the coating of the support with the paste or the gel is subjected to a drying stage prior to the phase of increasing the temperature to reach the temperature θ.

21. Process according to one of Claims 1 to 20, characterised in that the temperature θ, which is selected to produce said inorganic material from the precursor system containing the inorganic additive, is selected between 600°C and 1200°C.

22. Process according to one of Claims 1 to 21, characterised in that the rate of increase in temperature to reach the temperature θ is between 0.05°C and 20°C per minute.

23. Process according to Claim 22, characterised in that said rate of increase in temperature is between 0.1°C and 10°C per minute.

24. Process according to one of Claims 1 to 23, characterised in that the duration at which the combination precursor system/support is retained at the temperature 0 is between 30 minutes and 20 hours.

25. Process according to one of Claims 1 to 24, characterised in that the cooling of inorganic material/support assembly from the temperature 0 up to the ambient temperature is performed at cooling rates of from 0.05°C to 20°C per minute.

26. Process according to Claim 25, characterised in that said rates of cooling are from 0.1°C to 10°C per minute.

27. Process according to one of Claims 1 to 26, characterised in that the support which is used is a support of a metal or metal alloy, to the exclusion of any support of metal foam or metal felt, or a support of a ceramic material.

28. Process according to Claim 27, characterised in that said support is of platinum, brass, titanium, nickel, copper or stainless steel.

29. Process according to one of Claims 1 to 28, characterised in that there is used a smooth support, for example a smooth metallic support, and the inorganic material forming the target element is separated from the support.

30. Process according to one of Claims 1 to 28, characterised in that there is used a support which is not smooth in a material which is easily machinable and the inorganic material constituting the target element is separated mechanically from the support and the face of said target element which was in contact with the support is subjected to machining.

31. Process according to any one of Claims 1 to 28, characterised in that a rough support is used, of such a type that the inorganic material remains integral with the support, in such a manner as to form a supported target element constituting a target for cathode sputtering.

32. Process according to Claim 29 or 30, characterised in that the target element (2, 22) is associated with a substrate (4, 24) to constitute a target for cathode sputtering.

33. Process according to Claim 29 or 30, characterised in that the target element (2, 22) is adhered on a metal substrate (4, 24) by means of an adhesive (3, 23) which is a conductor of heat and electricity, to form a target for cathode sputtering.

34. Process according to claim 33, characterised in that said metal substrate is brass, aluminium, copper, titanium, tungsten or stainless steel.

35. Process according to Claims 33 or 34, characterised in that said adhesive is an adhesive consisting of a two-component conductive epoxy adhesive containing silver.

36. Process according to one of Claims 33 or 35, characterised in that the target element has a surface of the order of from 100 cm$^2$ to 1m$^2$ and the associated metal substrate has a corresponding surface.

37. Process according to one of Claims 33 to 35, characterised in that there is adhered, to a metal substrates having a given surface of the order of 100 cm$^2$ to 1m$^2$, a plurality of target elements, each having a surface which is less than said given surface, in such a manner that said elements are disposed connectively on said substrate and cover said given surface of the substrate.

38. Process according to one of Claims 33 to 37, characterised in that the target element or the plurality of target elements are adhered on the metal substrate in such a manner as to define, on the surface of the metal substrate on which the element or elements of the target are adhered, a marginal zone, (14, 34) surrounding the target element (2) or the plurality of connectively disposed target elements (22).

FIG.1a

FIG.1b

FIG.2a

FIG.2b